# EUROPÄISCHE PATENTSCHRIFT

(11) **EP 2 164 800 B1**
(45) Veröffentlichungstag und Bekanntmachung des Hinweises auf die Patenterteilung: **03.05.2017**
(21) Anmeldenummer: 08759742.3
(22) Anmeldetag: 19.05.2008
(51) Int. Cl.: B81B 7/00

(54) **MIKROMECHANISCHES BAUELEMENT UND VERFAHREN ZUR HERSTELLUNG EINES MIKROMECHANISCHEN BAUELEMENTS MIT EINER DÜNNSCHICHTKAPPE**
MICROMECHANICAL COMPONENT AND METHOD FOR PRODUCING A MICROMECHANICAL COMPONENT HAVING A THIN LAYER CAP
COMPOSANT MICROMÉCANIQUE ET PROCÉDÉ DE FABRICATION D'UN COMPOSANT MICROMÉCANIQUE COMPORTANT UNE COUVERTURE EN COUCHE MINCE

(30) Priorität: 01.06.2007 DE 102007025880
(43) Veröffentlichungstag der Anmeldung: 24.03.2010
(73) Patentinhaber: Robert Bosch GmbH, 70442 Stuttgart (DE)
(72) Erfinder: SCHMITZ, Volker, 72793 Pfullingen (DE); GROSSE, Axel, 72793 Pfullingen (DE)
(86) Internationale Anmeldenummer: PCT/EP2008/056117
(87) Internationale Veröffentlichungsnummer: WO 2008/145553

(56) Entgegenhaltungen:
- DE-A1- 10 017 422

## Beschreibung

### Stand der Technik

Die Erfindung geht von einem mikromechanische Bauelement nach dem Oberbegriff des Anspruchs 1 aus.

Solche mikromechanischen Bauelemente sind allgemein bekannt. Beispielsweise ist aus der Druckschrift EP1274648B1 ein mikromechanisches Bauelement und ein Verfahren zur Herstellung eines mikromechanischen Bauelements bekannt, welches eine Funktionsebene mit beweglichen und angebundenen Strukturen aufweist, wobei die angebundenen Strukturen durch Gräben und Oxidpfropfen, welche die Gräben ausfüllen, voneinander getrennt sind. Das Verfahren sieht zunächst die Bildung einer Funktionsschicht, eine nachfolgende Ätzung von Opferschichten durch die Gräben hindurch und einen abschließenden Verschluss der Gräben mittels der Oxidpfropfen vor. Eine Leitungsbahnebene zur Kontaktierung von beweglichen und angebundenen Strukturen der Funktionsschicht wird unterhalb der Funktionsschicht gebildet, wodurch eine Vielzahl von aufwändigen und kostenintensiven Prozessschritten erforderlich ist.

### Offenbarung der Erfindung

Das erfindungsgemäße mikromechanische Bauelement und das erfindungsgemäße Verfahren zur Herstellung eines erfindungsgemäßen mikromechanischen Bauelements gemäß den nebengeordneten Ansprüchen haben den Vorteil, dass eine gegenüber dem Stand der Technik deutlich geringere Anzahl von Prozessschritten zur Herstellung des mikromechanischen Bauelements, insbesondere bei der Herstellung von Sensoren und Aktoren, erreicht wird. Die Reduzierung der benötigten Prozessschritte erfolgt durch eine Verkappung des mikromechanische Bauelement wird mit einer Verkappungsschicht, insbesondere mit einer Dünnschichtkappe, wobei die Verkappungsschicht wenigstens den einen Graben aufweist, so dass elektrisch isolierte Verkappungsschichtelemente entstehen. Die Verkappungsschichtelemente werden gegebenenfalls in der Funktionsschicht und in einer oberen Metallschicht kontaktiert. So stehen die Verkappungsschichtelemente selbst als Leiterbahnen zur Verfügung und ermöglichen eine Leitungsbahnebene in der oberen Metallschicht. Aufwändige und kostenintensive Prozessschritte zur Erzeugung von Leiterbahnen und Leitungsbahnebenen unterhalb der Funktionsschicht entfallen. Vorzugsweise sind die Verkappungsschichtelemente von wenigstens einem Graben vollständig umgeben. Zur mechanischen Anbindung der Verkappungsschichtelemente ist wenigstens der eine elektrisch isolierende Verbindungssteg vorgesehen, wobei vorzugsweise der Verbindungssteg und die Verkappungsschicht zum Zeitpunkt des Aufbringens der Verkappungsschicht einstückig verbunden sind. Durch eine stabile mechanische Fixierung des Verkappungsschichtelements wird insbesondere eine Verbindung zwischen dem Verkappungsschichtelement und einer Struktur der Funktionsschicht, welche in der Funktionsschicht keine Fixierung aufweist, ermöglicht, da das Verkappungsschichtelement in diesem Fall als Halterung für die Struktur und gleichzeitig als Leiterbahn zur elektrischen Kontaktierung der Struktur fungiert.

Gemäß einer bevorzugten Weiterbildung weist eine Flächennormale einer Grabenwand des Grabens bezüglich einer zur Haupterstreckungsebene des Substrats senkrechten Richtung wenigstens zwei verschiedene Winkel auf. Ein solches Profil ermöglicht einen Verbindungssteg, dessen Ausdehnung entlang einer zur Haupterstreckungsebene senkrechten Richtung variabel ist und entsprechend an die geforderte Anforderung an die Isolationsfähigkeit und die mechanische Belastbarkeit angepasst wird. Insbesondere ist ein Verbindungsstege mit einer geringeren Ausdehnung als die Verkappungsschichtdicke vorgesehen.

Ein weiterer Gegenstand der vorliegenden Erfindung ist ein Verfahren zur Herstellung eines mikromechanischen Bauelements, wobei in einem ersten Verfahrensschritt das Substrat mit der ersten Isolationsschicht und der Funktionsschicht versehen wird, bevorzugt ist ein SOI-Wafer vorgesehen, wobei in einem zweiten Verfahrensschritt die Funktionsschicht, bevorzugt durch ein bekannten Trench-Prozess, besonders bevorzugt durch einen Bosch- oder DRIE-Prozess, strukturiert wird, wobei in einem dritten Verfahrensschritt die zweite Isolationsschicht aufgebracht wird, wobei in einem vierten Verfahrensschritt die zweite Isolationsschicht strukturiert wird, wobei in einem fünften Verfahrensschritt die Verkappungsschicht, insbesondere eine Siliziumdünnschichtkappe, aufgebracht wird und wobei in einem sechsten Verfahrensschritt die Verkappungsschicht mit wenigstens dem einen Graben versehen wird, wobei wenigsten der eine Verbindungssteg der Verkappungsschicht zur Überbrückung des Grabens bei der Grabenbildung stehen gelassen wird. Dadurch entstehen Verkappungsschichtelemente, welche als Leiterbahnen fungieren und gleichzeitig mechanisch fixiert sind. Des weiteren entsteht durch den Graben ein Zugang zur Funktionsschicht des mikromechanischen Bauelements, so dass in späteren Verfahrensschritten Ätzvorgänge und/oder Oxidationsvorgänge in der Verkappungsschicht und/oder der Funktionsschicht ermöglicht werden. Insbesondere ist eine Dotierung und/oder eine Temperung der Verkappungsschicht vorgesehen. Die Isolationsschichten dienen bevorzugt der elektrischen und räumlichen Trennung der angrenzenden Schichten, sowie besonders bevorzugt als Schutz- und Opferschichten.

Gemäß einer bevorzugten Weiterbildung wird im Anschluss an den sechsten Verfahrensschritt in einem siebten Verfahrensschritt die erste und/oder die zweite Isolationsschicht von einem Ätzmittel durch den Graben hindurch geätzt. Durch die Ätzung entstehen in der Funktionsebene insbesondere bewegliche Strukturen. Die mechanische Fixierung der Verkappungsschichtelemente durch die Verbindungsstege ermöglicht insbesondere eine Unterätzung von Elementen in der Funktionsschicht, welche nicht in der Funktionsschicht selbst fixiert sind, sondern lediglich eine Verbindung zu einem Verkappungsschichtelement aufweisen und durch dieses kontaktiert werden. Solche Strukturen fungieren insbesondere als Elektroden.

Gemäß einer weiteren bevorzugten Weiterbildung wird im Anschluss an den siebten Verfahrensschritt in einem achten Verfahrensschritt ein Oxidationsverfahren, bevorzugt eine thermische Oxidation, durchgeführt, wobei insbesondere eine dritte Isolationsschicht zum Verschließen der Verkappungsschicht gebildet wird und/oder eine Oxidation des Verbindungsstegs zur Verringerung der elektrischen Leitfähigkeit erfolgt. Bevorzugt wird der Verschluss der Verkappungsschicht in zwei aufeinanderfolgende Verfahrensteilschritte unterteilt, wobei in einem ersten Verfahrensteilschritt die thermische Oxidation wenigstens der einen Verbindungsbrücke erfolgt, wobei insbesondere der Graben teilweise verschlossen wird, und in einem zweiten Verfahrensteilschritt eine Oxidation zum vollständigen Verschluss des Grabens und/oder von Grabenteilbereichen durchgeführt wird. Vorteilhaft ist, dass der Druckbereich des mikromechanischen Bauelements im Oxidationsvorgang einstellbar ist.

Gemäß einer weiteren bevorzugten Weiterbildung wird in einem auf den achten Verfahrensschritt folgenden neunten Verfahrensschritt eine Strukturierung der dritten Isolationsschicht durchgeführt und in einem nachfolgenden zehnten Verfahrensschritt eine Leiterbahn, vorzugsweise aus Metall, auf die dritte Isolationsschicht aufgebracht, wobei insbesondere das Verkappungsschichtelement von der Leiterbahn kontaktiert wird. Durch die Kontaktierung des Verkappungsschichtelements fungiert dieses als Leiterbahn und ermöglicht eine Leiterbahnebene auf der Verkappungsschicht. Durch die mögliche Kontaktierung isolierter Verkappungsschichtelemente sind insbesondere Kreuzungen zweier elektrisch getrennter Metallleiterbahnen auf einer Metallebene möglich.

Gemäß einer weiteren bevorzugten Weiterbildung wird im Anschluss an den zehnten Verfahrensschritt in einem elften Verfahrensschritt eine Schutzebene aufgebracht und strukturiert wird, wobei insbesondere die Schutzebene aus Polyimid gebildet wird. Die Schutzebene minimiert die Stressempfindlichkeit des mikromechanischen Bauelements, insbesondere in einem nachfolgenden Verpackungsprozess,

Gemäß einer weiteren bevorzugten Weiterbildung wird im sechsten Verfahrensschritt eine Flächennormale einer Grabenwand des Grabens bezüglich einer zur Haupterstreckungsebene des Substrats senkrechten Richtung mit wenigstens zwei unterschiedlichen Winkeln versehen. Bevorzugt wird der Graben durch einen Trench-Prozess gebildet, welcher zunächst mit einem hohen und später mit einem geringen Kantenverlust durchgeführt wird, so dass die Verbindungsstege unterhöhlt werden. Ein solches Profil ermöglicht einen Verbindungssteg, dessen Ausdehnung entlang einer zur Haupterstreckungsebene senkrechten Richtung variabel ist und entsprechend an die geforderte Anforderung an die Isolationsfähigkeit und die mechanische Belastbarkeit angepasst wird.

### Kurze Beschreibung der Zeichnung

Ausführungsbeispiele der Erfindung sind in den Zeichnungen dargestellt und in der nachfolgenden Beschreibung näher erläutert.

Es zeigen:
Figuren 1a bis 1 k zeigen eine schematische Darstellung der Herstellungsschritte zur Herstellung eines mikromechanischen Bauelements gemäß einer ersten Ausführungsform der vorliegenden Erfindung.
Figur 2 zeigt eine schematische Darstellung eines mikromechanischen Bauelements gemäß einer zweiten Ausführungsform der vorliegenden Erfindung.
Figuren 3a und 3c zeigen jeweils eine schematische Aufsicht eines Teilelements des erfindungsgemäßen mikromechanischen Bauelements gemäß der ersten oder der zweiten Ausführungsform. In den Figuren 3b und 3d ist jeweils eine schematische Seitenansicht desselben Teilelements in einer Schnittebene, welche in der jeweiligen Aufsicht schematisch eingezeichnet ist, dargestellt.

Die Figuren 4a bis 4c zeigen unterschiedliche Varianten eines Teilbereichs des erfindungsgemäßen mikromechanischen Bauelements gemäß der ersten oder der zweiten Ausführungsform.

Figur 5 zeigt eine Aufsicht eines mikromechanischen Bauelements gemäß einer weiteren Ausführungsform der vorliegenden Erfindung.

In den verschiedenen Figuren sind gleiche Teile stets mit den gleichen Bezugszeichnen versehen und werden daher in der Regel auch jeweils nur einmal beschriftet.

### Ausführungsform(en) der Erfindung

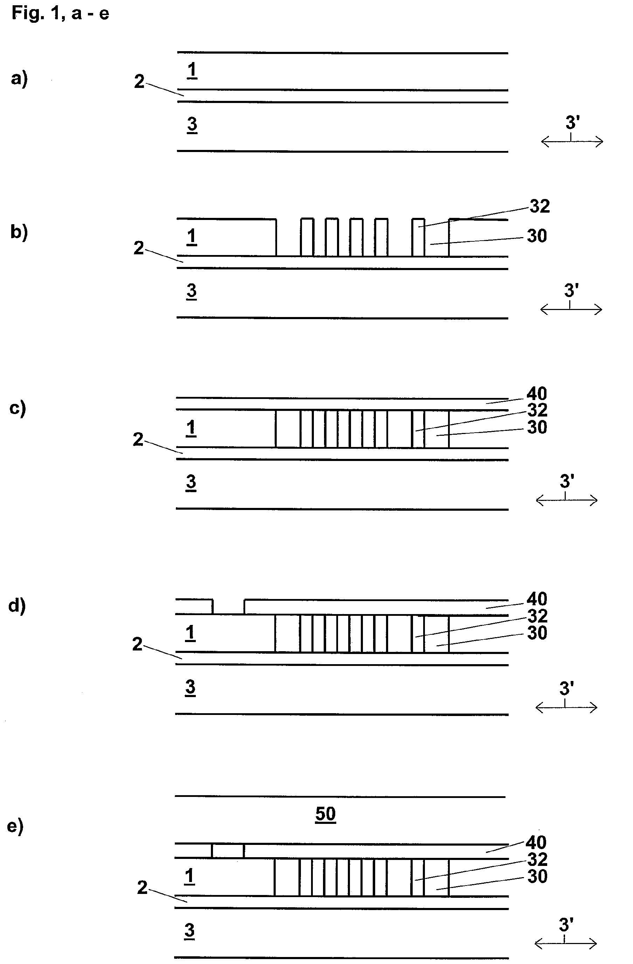

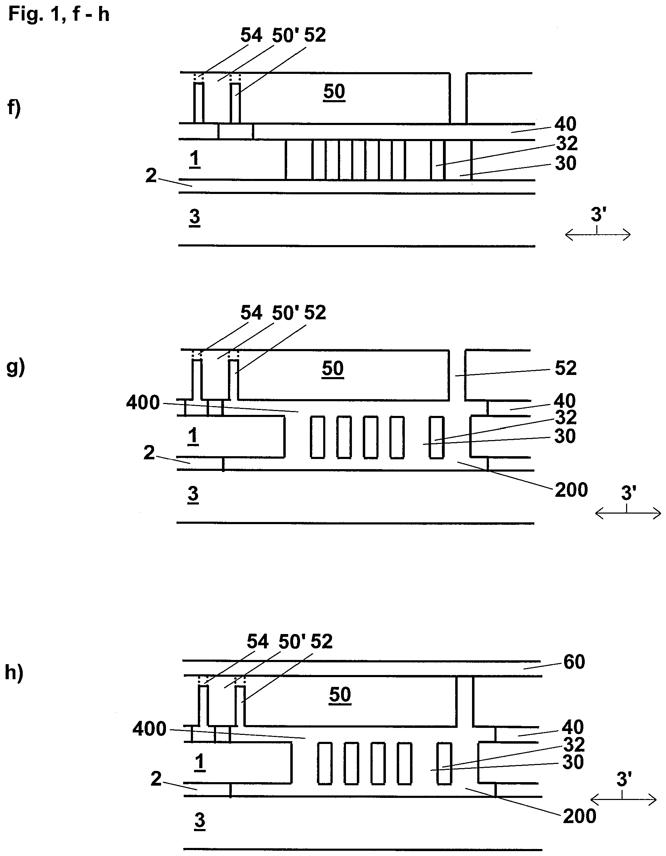

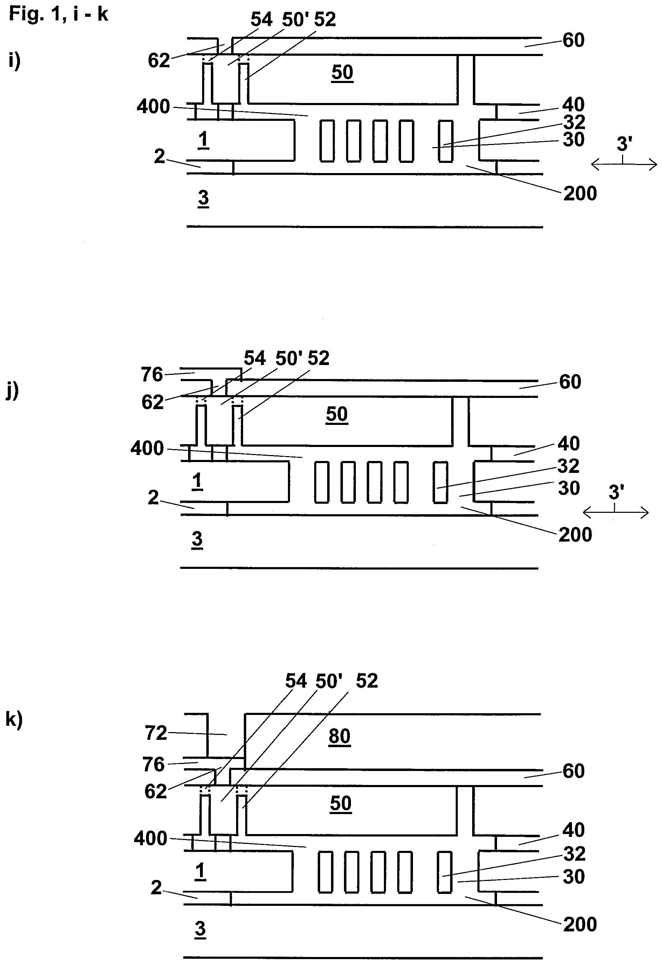

Zur Veranschaulichung des erfindungsgemäßen Verfahrens zur Herstellung eines mikromechanischen Bauelements gemäß einer ersten Ausführungsform sind in den Figuren 1a bis 1 k die Herstellungsschritte des mikromechanischen Bauelements anhand einer Mehrzahl von Vorläuferstrukturen des mikromechanischen Bauelements schematisch dargestellt. In Figur 1a ist eine erste Vorläuferstruktur dargestellt, welche ein Substrat 3 darstellt, wobei das Substrat 3, insbesondere ein Siliziumsubstrat, mit einer ersten Isolationsschicht 2 und einer über der ersten Isolationsschicht 2 liegenden Funktionsschicht 1, vorzugsweise eine Epi-Si-Poly-oder Si-Poly-Schicht, versehen wird, wobei insbesondere ein Vorgang zur Planarisierung der Funktionsschicht 1 vorgesehen ist. In der Figur 1 b ist eine zweite Vorläuferstruktur zur Veranschaulichung des zweiten Verfahrensschritts dargestellt, wobei die Funktionsschicht 1, insbesondere zur Erzeugung von beweglichen Teilen 32 und Hohlräumen 30 in der Funktionsschicht 1, strukturiert wird. Ein dritter Verfahrensschritt ist anhand einer dritten Vorläuferstruktur in Figur 1 c illustriert, wobei eine zweite Isolationsschicht 40, insbesondere eine Oxidschicht, aufgebracht wird und wobei vorzugsweise eine Planarisierung der Isolationsschicht 40 durchgeführt wird. In Figur 1d wird eine vierte Vorläuferstruktur zur Veranschaulichung eines vierten Verfahrensschritts dargestellt, wobei die zweite Isolationsschicht 40 strukturiert wird, vorzugsweise zur Resistenzbildung von Teilen der zweiten Isolationsschicht 40 gegen einen zeitlich späteren Ätzvorgang. Zur Veranschaulichung eines fünften Verfahrensschrittes wird in Figur 1 e eine Vorläuferstruktur dargestellt, wobei eine Verkappungsschicht 50, insbesondere eine Silizium-Dünnschichtkappe, aufgebracht wird, wobei bevorzugt ein Epitaxieverfahren verwendet wird. Ein nachfolgender sechster Verfahrensschritt wird mit Hilfe einer sechsten Vorläuferstruktur in Figur 1f dargestellt, wobei die Verkappungsschicht, vorzugsweise mit einem Trench-Prozess, strukturiert wird, so dass wenigstens ein Graben 52 entsteht, wobei wenigstens ein Verbindungssteg 54 der Verkappungsschicht 50 zur Überbrückung des Grabens 52 im Strukturierungsprozess stehen bleibt. Die Ausbildung des Verbindungsstegs 54 wird insbesondere durch einen Trench-Prozess des Grabens 52 durchgeführt, wobei zu Beginn ein geringer Kantenverlust und anschließend einer höherer Kantenverlust vorgesehen ist, so dass der Verbindungssteg unterhöhlt wird und somit nur über einen Teil der Verkappungsschichtdicke ausgebildet ist. Insbesondere ist eine vollständige Umschließung eines Verkappungsschichtelements 50' durch wenigstens einen Graben 52 vorgesehen. In Figur 1g wird anhand einer siebten Vorläuferstruktur ein siebter Verfahrensschritt dargestellt, wobei eine Opferschichtätzung der ersten und/oder zweiten Isolationsschicht 2, 40 durchgeführt wird, wobei bevorzugt ein Ätzmittel durch den Graben 52 hindurch den Isolationsschichten 2, 40 zugeführt wird und wobei besonders bevorzugt in der Funktionsebene 1 bewegliche Strukturen 32 gebildet werden. Anhand einer in Figur 1 h illustrierten achten Vorläuferstruktur wird ein achter Verfahrensschritt dargestellt, wobei ein Oxidationsverfahren, bevorzugt ein thermisches Oxidationsverfahren, durchgeführt wird, welches die elektrische Leitfähigkeit des Verbindungsstegs 54 reduziert und insbesondere einen Verschluss der Verkappungsschicht 50 durch eine dritte Isolationsschicht 60 bildet. Dabei wird eine höhere Oxidationsrate an der Oberfläche der Verkappungsschicht 50 als im Innern der Verkappungsschicht 50 und/oder im Innern der Funktionsschicht 1 erreicht, da dort der Gasfluss beim Oxidationsvorgang geringer ist. In Figur 1 i ist anhand einer neunten Vorläuferstruktur ein neunter Verfahrensschritt dargestellt, wobei die dritte Isolationsschicht 60 strukturiert wird. Eine zehnte Vorläuferstruktur illustriert in Figur 1j stellt einen zehnten Verfahrensschritt zum Aufbringen einer Leiterbahn 76, insbesondere einer Leiterbahn 76 aus Metall, auf die dritte Isolationsschicht 60 dar, wobei insbesondere das Verkappungsschichtelement 50' von der Leiterbahn 76 kontaktiert wird und zusammen mit der Leiterbahn 76 eine elektrisch leitende Verbindung bildet. In Figur 1 k wird anhand einer beispielhaften Struktur eines erfindungsgemäßen Bauelements gemäß einer ersten Ausführungsform ein elfter Verfahrensschritt dargestellt, wobei eine Schutzebene 80 auf die Oberfläche des mikromechanischen Bauelements, vorzugsweise aus Polyimid, aufgebracht wird, um die Stressempfindlichkeit des mikromechanischen Bauelements herabzusetzen.

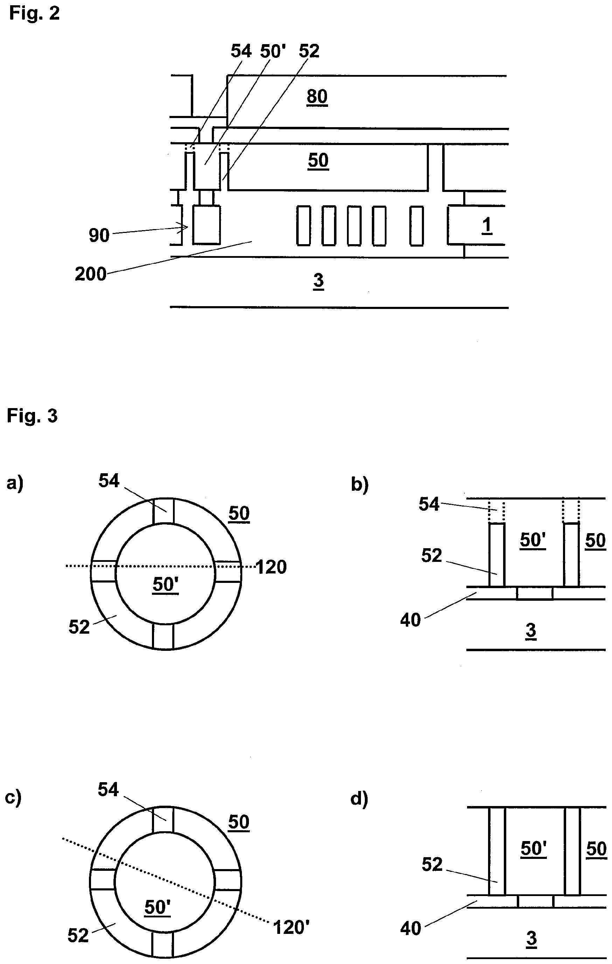

In Figur 2 ist beispielhaft die Struktur eines mikromechanischen Bauelements gemäß einer zweiten Ausführungsform der vorliegenden Erfindung gezeigt, welche jedoch im wesentlichen auf der Struktur des mikromechanischen Bauelements gemäß der ersten Ausführungsform (Figur 1 k) basiert. Daher wird im Folgenden lediglich auf die Besonderheiten der zweiten Ausführungsform gegenüber der ersten Ausführungsform der vorliegenden Erfindung näher eingegangen.
Das erfindungsgemäße mikromechanische Bauelement gemäß einer zweiten Ausführungsform weist ein Verkappungsschichtelement 50' in einer Verkappungsschicht 50 gemäß des in Figur 1 k dargestellten erfindungsgemäßen mikromechanischen Bauelements einer ersten Ausführungsform auf, welches mit einer Struktur 90 in der Funktionsschicht mechanisch stabil verbunden ist, wobei die Struktur 90 im Unterschied zum erfindungsgemäßen mikromechanischen Bauelements gemäß einer ersten Ausführungsform (Figur 1 k) in der Funktionsschicht keine mechanische Fixierung aufweist. Das Verkappungsschichtelement weist einen elektrisch leitenden Kontakt mit einer Leiterbahn 76 auf, wobei das Verkappungsschichtelement 50' über Verbindungsstege 54 mechanisch fixiert wird. Eine derartige Struktur wird durch einen erfindungsgemäßen Graben 52 mit Verbindungsstegen 54 ermöglicht, wobei die Verbindungsstege 54 einerseits eine mechanische Fixierung des Verkappungsschichtelements 50' und andererseits eine Grabenöffnung als Ätzzugang ermöglichen. Des weiteren wird durch eine zumindest teilweise Oxidation der Verbindungsstege 54 eine elektrische Isolierung des Verkappungsschichtelements 50' von der Verkappungsschicht 50 erzielt.

In den Figuren 3a und 3c ist beispielhaft jeweils eine schematische Aufsicht eines erfindungsgemäßen Teilelements des mikromechanischen Bauelements gemäß der ersten Ausführungsform (Figur 1 k) oder der zweiten Ausführungsform (Figur 2) der vorliegenden Erfindung beispielhaft dargestellt, während die Figuren 3b und 3d jeweils eine beispielhafte schematische Seitenansicht desselben Teilelements in einer Schnittebene, welche in der jeweiligen Aufsicht schematisch eingezeichnet ist 120, 120', darstellen. In Figur 3a ist eine Aufsicht einer Verkappungsschicht 50 dargestellt, wobei die Verkappungsschicht 50 ein Verkappungsschichtelement 50' aufweist, welches von der Verkappungsschicht 50 durch einen Graben 52 beabstandet und über Verbindungsstege 54 mechanisch fixiert ist. Eine Querschnittslinie 120 illustriert einen Querschnitt der Struktur, welcher in Figur 3b abgebildet ist und ebenfalls die Verkappungsschicht 50 mit dem durch den Graben 52 zur Verkappungsschicht 50 beabstandeten Verkappungsschichtelement 50' darstellt. Da in der Aufsichtsdarstellung der Figur 3a die Querschnittslinie 120 die Verbindungsstege 54 schneidet, sind die Verbindungsstege 54 ebenfalls in der Querschnittsdarstellung der Figur 3c abgebildet. In Figur 3b ist gleichermaßen eine Aufsicht desselben Teilbereich des mikromechanischen Bauelements abgebildet, wobei die Darstellung eine Querschnittslinie 120' derart aufweist, dass die Querschnittslinie 120' die Verbindungsstege 54 nicht schneidet. In Figur 3d, welche die Querschnittsabbildung derselben Struktur der Figur 3b entlang der Querschnittslinie 120' darstellt, sind folglich die Verbindungsstege 54 nicht abgebildet, sondern der Graben 52 erstreckt sich über die gesamte Verkappungsschichtdicke.

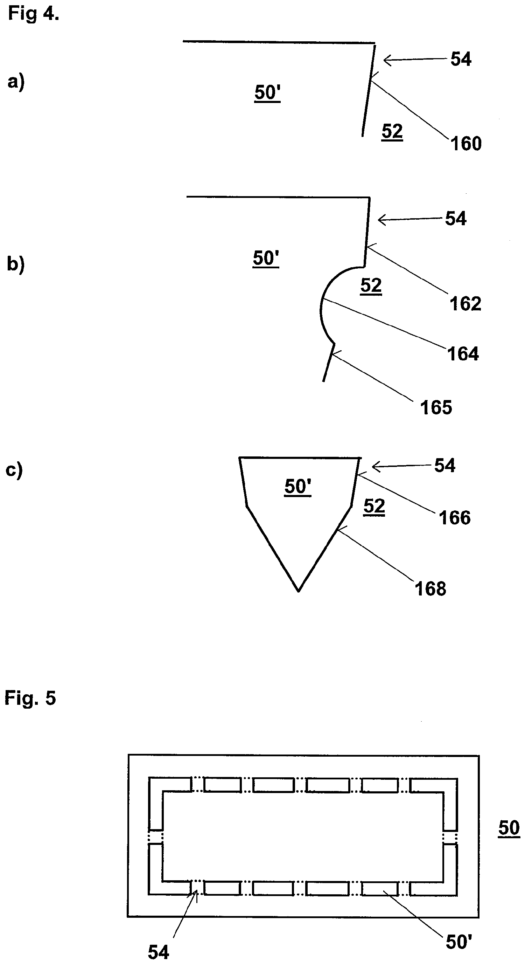

Die Figuren 4a bis 4c zeigen unterschiedliche Varianten eines Teilbereichs des erfindungsgemäßen mikromechanischen Bauelements gemäß der ersten oder der zweiten Ausführungsform (Figur 1 k, 2). In den Figuren 4a bis 4c sind Grabenwände 160 bis 168 eines beispielhaften Grabens 52 in der Verkappungsschicht 50 des erfindungsgemäßen mikromechanischen Bauelements gemäß der ersten oder der zweiten Ausführungsformen dargestellt, wobei die Grabenwände unterätzt sind und Flächennormale der Grabenwände je nach Trench-Prozess gegenüber einer zur Haupterstreckungsebene 3' senkrechten Richtung in der schematischen Darstellung in der Figur 4a genau einen Winkel, in der schematischen Darstellung in der Figur 4b mehrere Winkel oder in der schematischen Darstellung in der Figur 4c zwei Winkel aufweisen. Dadurch können Verbindungsstege 54 mit verschiedenen Profilen, je nach Anforderung an die elektrische Isolierfähigkeit und/oder an die mechanische Verbindungsfestigkeit, versehen werden.

In der Figur 5 ist eine Aufsicht des erfindungsgemäßen mikromechanischen Bauelements gemäß einer weiteren Ausführungsform schematisch dargestellt, wobei eine Verkappungsschicht 50 und elektrisch isolierte Verkappungsschichtelemente 50', welche durch Verbindungsstege 54 mechanisch fixiert sind, dargestellt sind. Die Verkappungsschichtelemente 50 bilden Leiterbahnen zur Kontaktierung und/oder zur mechanischen Fixierung von in der Funktionsebene 1 angeordneten Strukturen, welche bevorzugt als Elektroden fungieren.

## Patentansprüche

1. Mikromechanisches Bauelement mit einem Substrat (3), einer über dem Substrat (3) liegenden mikromechanische Funktionsschicht (1) und einer über der Funktionsschicht (1) liegenden Verkappungsschicht (50), wobei die Verkappungsschicht (50) wenigstens einen Graben (52) aufweist, **dadurch gekennzeichnet, dass** eine Überbrückung des Grabens (52) durch wenigstens einen elektrisch isolierenden Verbindungssteg (54) vorgesehen ist.

2. Mikromechanisches Bauelement gemäß Anspruch 1, **dadurch gekennzeichnet, dass** an den Graben (52) angrenzende Verkappungsschichtelemente (50') eine feste mechanische Verbindung über den Verbindungssteg (54) aufweisen.

3. Mikromechanisches Bauelement gemäß einem der vorhergehenden Ansprüche, **dadurch gekennzeichnet, dass** das Verkappungsschichtelement (50) vollständig von wenigstens dem einen Graben (52) umgeben ist.

4. Mikromechanisches Bauelement gemäß einem der vorhergehenden Ansprüche, **dadurch gekennzeichnet, dass** eine Flächennormale einer Grabenwand (166, 168) des Grabens (52) bezüglich einer zur Haupterstreckungsebene (3') des Substrats (3) senkrechten Richtung wenigstens zwei verschiedene Winkel aufweist.

5. Verfahren zur Herstellung eines mikromechanischen Bauelements gemäß einem der vorhergehenden Ansprüche, wobei in einem ersten Verfahrensschritt das Substrat (3) mit einer ersten Isolationsschicht (2) und der Funktionsschicht (1) versehen wird, wobei in einem zweiten Verfahrensschritt die Funktionsschicht (1) strukturiert wird, wobei in einem dritten Verfahrensschritt eine zweite Isolationsschicht (40) aufgebracht wird, wobei in einem vierten Verfahrensschritt die zweite Isolationsschicht (40) strukturiert wird, wobei in einem fünften Verfahrensschritt die Verkappungsschicht (50) aufgebracht wird und wobei in einem sechsten Verfahrensschritt die Verkappungsschicht (50) mit wenigstens dem einen Graben (52) versehen wird, **dadurch gekennzeichnet, dass** wenigstens der eine Verbindungssteg (54) der Verkappungsschicht (50) zur Überbrückung des Grabens (52) stehen gelassen wird.

6. Verfahren gemäß Anspruch 5, **dadurch gekennzeichnet, dass** in einem nachfolgenden siebten Verfahrensschritt die erste und/oder die zweite Isolationsschicht (2, 40) von einem Ätzmittel durch den Graben (52) hindurch geätzt wird.

7. Verfahren gemäß einem der Ansprüche 5 und 6, **dadurch gekennzeichnet, dass** in einem nachfolgenden achten Verfahrensschritt ein Oxidationsverfahren durchgeführt wird, wobei insbesondere eine dritte Isolationsschicht (60) gebildet und/oder die Verbindungsstege (54) oxidiert werden.

8. Verfahren gemäß dem Anspruch 7, **dadurch gekennzeichnet, dass** in einem nachfolgenden neunten Verfahrensschritt eine Strukturierung der dritten Isolationsschicht (60) durchgeführt wird.

9. Verfahren gemäß einem der Ansprüche 5 bis 8, **dadurch gekennzeichnet, dass** in einem nachfolgenden zehnten Verfahrensschritt eine Leiterbahn (76) auf die dritte Isolationsschicht (60) aufgebracht wird, wobei insbesondere ein Verkappungsschichtelement (50') von der Leiterbahn (76) kontaktiert (62) wird.

10. Verfahren gemäß einem der Ansprüche 5 bis 9, **dadurch gekennzeichnet, dass** in einem elften Verfahrensschritt eine Schutzebene (80) aufgebracht und strukturiert wird, wobei insbesondere die Schutzebene aus Polyimid gebildet wird.

11. Verfahren gemäß einem der Ansprüche 5 bis 10, **dadurch gekennzeichnet, dass** im sechsten Verfahrensschritt eine Flächennormale einer Grabenwand (166, 168) des Grabens (52) bezüglich einer zur Haupterstreckungsebene (3') des Substrats (3) senkrechten Richtung mit wenigstens zwei unterschiedlichen Winkeln versehen wird.

## Claims

1. Micromechanical component comprising a substrate (3), a micromechanical functional layer (1) lying above the substrate (3), and a capping layer (50) lying above the functional layer (1), wherein the capping layer (50) has at least one trench (52), **characterized in that** a bridging of the trench (52) by at least one electrically insulating connecting web (54) is provided.

2. Micromechanical component according to Claim 1, **characterized in that** capping layer elements (50') adjoining the trench (52) have a fixed mechanical connection via the connecting web (54).

3. Micromechanical component according to either of the preceding claims, **characterized in that** the capping layer element (50) is completely surrounded by at least the one trench (52).

4. Micromechanical component according to any of the preceding claims, **characterized in that** a surface normal of a trench wall (166, 168) of the trench (52) has at least two different angles with respect to a direction perpendicular to the main extension plane (3') of the substrate (3).

5. Method for producing a micromechanical component according to any of the preceding claims, wherein in a first method step the substrate (3) is provided with a first insulation layer (2) and the functional layer (1), wherein in a second method step the functional layer (1) is structured, wherein in a third method step a second insulation layer (40) is applied, wherein in a fourth method step the second insulation layer (40) is structured, wherein in a fifth method step the capping layer (50) is applied, and wherein in a sixth method step the capping layer (50) is provided with at least the one trench (52), **characterized in that** at least the one connecting web (54) of the capping layer (50) is left for bridging the trench (52).

6. Method according to Claim 5, **characterized in that** in a subsequent seventh method step the first and/or the second insulation layer (2, 40) are/is etched by an etchant through the trench (52).

7. Method according to either of Claims 5 and 6, **characterized in that** in a subsequent eighth method step an oxidation method is carried out, wherein in particular a third insulation layer (60) is formed and/or the connecting webs (54) are oxidized.

8. Method according to Claim 7, **characterized in that** in a subsequent ninth method step a structuring of the third insulation layer (60) is carried out.

9. Method according to any of Claims 5 to 8, **characterized in that** in a subsequent tenth method step a conductor track (76) is applied to the third insulation layer (60), wherein in particular a capping layer element (50') is contacted (62) by the conductor track (76).

10. Method according to any of Claims 5 to 9, **characterized in that** in an eleventh method step a protection plane (80) is applied and structured, wherein in particular the protection plane is formed from polyimide.

11. Method according to any of Claims 5 to 10, **characterized in that** in the sixth method step a surface normal of a trench wall (166, 168) of the trench (52) is provided with at least two different angles with respect to a direction perpendicular to the main extension plane (3') of the substrate (3).

## Revendications

1. Composant micromécanique comportant un substrat (3), une couche fonctionnelle micromécanique (1) se situant sur le substrat (3) et une couche d'encapsulation (50) se situant sur la couche fonctionnelle (1), dans lequel la couche d'encapsulation (50) comporte au moins une tranchée (52), **caractérisé en ce qu'**il est prévu un pontage de la tranchée (52) par au moins une barre de liaison (54) électriquement isolante.

2. Composant micromécanique selon la revendication 1, **caractérisé en ce que** des éléments de couche d'encapsulation (50') adjacents à la tranchée (52) comportent une liaison mécanique solide par l'intermédiaire de la barre de liaison (54).

3. Composant micromécanique selon l'une quelconque des revendications précédentes, **caractérisé en ce que** l'élément de couche, d'encapsulation (50) est entièrement entouré par l'au moins une tranchée (52).

4. Composant micromécanique selon l'une quelconque des revendications précédentes, **caractérisé en ce qu'**une normale à la surface d'une paroi de tranchée (166, 168) de la tranchée (52) présente au moins deux angles différents par rapport à une direction perpendiculaire au plan d'extension principal (3') du substrat (3).

5. Procédé de réalisation d'un composant micromécanique selon l'une quelconque des revendications précédentes, dans lequel, lors d'une première étape de procédé, le substrat (3) est muni d'une première couche d'isolation (2) et de la couche fonctionnelle (1), dans lequel, lors d'une deuxième étape de procédé, la couche fonctionnelle (1) est structurée, dans lequel, lors d'une troisième étape de procédé, une deuxième couche d'isolation (40) est déposée, dans lequel, lors d'une quatrième étape de procédé, la deuxième couche d'isolation (40) est structurée, dans lequel, lors d'une cinquième étape de procédé, la couche d'encapsulation (50) est déposée et dans lequel, lors d'une sixième étape de procédé, la couche d'encapsulation (50) est munie d'au moins une tranchée (52), **caractérisé en ce que** l'au moins une barre de liaison (54) de la couche d'encapsulation (50) est laissée en place pour le pontage de la tranchée (52).

6. Procédé selon la revendication 5, **caractérisé en ce que**, lors d'une septième étape de procédé suivante, la première et/ou la deuxième couche d'isolation (2, 40) est/sont attaquée(s) par un agent d'attaque à travers la tranchée (52).

7. Procédé selon l'une quelconque des revendications 5 et 6, **caractérisé en ce que**, lors d'une huitième étape de procédé suivante, un procédé d'oxydation est effectué, dans lequel, en particulier, une troisième couche d'isolation (60) est formée et/ou les barres de liaison (54) sont oxydées.

8. Procédé selon la revendication 7, **caractérisé en ce que**, lors d'une suivante neuvième étape de procédé, une structuration de la troisième couche d'isolation (60) est effectuée.

9. Procédé selon l'une quelconque des revendications 5 à 8, **caractérisé en ce que**, lors d'une dixième étape de procédé suivante, une piste conductrice (76) est déposée sur la troisième couche d'isolation (60), dans lequel un contact (62) est notamment établi avec un élément de couche d'encapsulation (50') de la piste conductrice (76).

10. Procédé selon l'une quelconque des revendications 5 à 9, **caractérisé en ce que**, lors d'une onzième étape de procédé, un plan de protection (80) est déposé et structuré, dans lequel le plan de protection est notamment constitué de polyimide.

11. Procédé selon l'une quelconque des revendications 5 à 10, **caractérisé en ce que**, lors de la sixième étape de procédé, une normale à la surface d'une paroi de tranchée (166, 168) de la tranchée (52) est munie d'au moins deux angles différents par rapport à une direction perpendiculaire au plan d'extension principal (3') du substrat (3).
